Europäisches Patentamt

European Patent Office

Office européen des brevets

(19)

(11) **EP 0 771 463 B1**

(12) **EUROPÄISCHE PATENTSCHRIFT**

(45) Veröffentlichungstag und Bekanntmachung des Hinweises auf die Patenterteilung:
**01.07.1998 Patentblatt 1998/27**

(21) Anmeldenummer: **95918529.9**

(22) Anmeldetag: **18.05.1995**

(51) Int Cl.[6]: **G11C 8/00**, G06T 3/60

(86) Internationale Anmeldenummer:
**PCT/DE95/00660**

(87) Internationale Veröffentlichungsnummer:
**WO 96/02915 (01.02.1996 Gazette 1996/06)**

(54) **VERFAHREN UND VORRICHTUNG ZUM SPEICHERN UND DREHEN VON BITMUSTERN**

PROCESS AND DEVICE FOR STORING AND ROTATING BIT CONFIGURATIONS

PROCEDE ET DISPOSITIF PERMETTANT DE MEMORISER ET DE FAIRE TOURNER DES CONFIGURATIONS BINAIRES

(84) Benannte Vertragsstaaten:
**BE DE FR GB**

(30) Priorität: **13.07.1994 DE 4424734**

(43) Veröffentlichungstag der Anmeldung:
**07.05.1997 Patentblatt 1997/19**

(73) Patentinhaber: **Océ Printing Systems GmbH**
**85586 Poing (DE)**

(72) Erfinder: **SCHNEIDER, Claus**
**D-81739 München (DE)**

(74) Vertreter: **Schaumburg, Thoenes, Thurn**
**Patentanwälte**
**Postfach 86 07 48**
**81634 München (DE)**

(56) Entgegenhaltungen:
**US-A- 4 875 190**        **US-A- 4 935 897**

**Beschreibung**

Die Erfindung betrifft ein Verfahren und Vorrichtung zum Speichern und Drehen von Bitmustern. Die Bitmuster sind in Matrixzellen einer Speichermatrix einschreibbar und wieder auslesbar. Ein Bitmuster repräsentiert eine in ihre einzelnen Pixel (Bildpunkte) aufgelöste Bildinformation. Solche Bildinformationen werden beispielsweise bei Bildschirmgeräten und sonstigen Anzeigeeinheiten und bei Kopier- und Druckgeräten zur Wiedergabe der Bildinformation auf einem Aufzeichnungsträger verarbeitet.

Aus US 5 012 434 ist ein elektrografischer Drucker bekannt, der von einem Datenverarbeitungsgerät zu druckende Bildinformationen erhält. Diese codierte Bildinformation wird von einem Druckercontroller in ein Bitmuster umgesetzt und gegebenenfalls gedreht. Das Bitmuster wird an eine nachgeordnete Wiedergabeeinrichtung ausgelesen, die das Bitmuster und damit die Bildinformation auf einen Aufzeichnungsträger überträgt.

Zum Drehen von Bitmustern werden üblicherweise Speichermatrizen verwendet, auf deren Matrixzellen mit Hilfe von peripheren Auswahlelementen wahlfrei zugegriffen werden kann. So ist es beispielsweise möglich, ganze Zeilen oder ganze Spalten parallel aus der Speichermatrix einzuschreiben und auszulesen. Jede Matrixzelle weist dazu genau eine Speicherzelle auf, in der ein Pixel in Form einer logischen Null oder Eins ablegbar ist. Jede Matrixzelle ist über je eine erste Leitung mit einem Zeilenmultiplexer und über eine zweite Leitung mit einem Spaltenmultiplexer verbunden. Die Spaltenmultiplexer und Zeilenmultiplexer dienen dabei als periphere Auswahlelemente. Abhängig von der Größe der Speichermatrix wird deshalb eine Vielzahl von Leitungen von den Matrixzellen zur Matrixperipherie benötigt. Dadurch wird die Größe einer realisierbaren Matrix begrenzt.

Aus US-A-4 935 897 ist eine Speichereinheit zur den Einsatz in einem Drucker bekannt. Die Speichereinheit kann als Pufferspeicher für Bilddaten verwendet werden. An jedem Matrixpunkt der Speichereinheit kann dabei ein Bildpunkt gespeichert werden. Durch gezielte Steuerung mittels eines Reihendecoders und eines Spaltendecoders können Bildpunkte so ausgelesen werden, daß damit eine Bilddrehungen erfolgt.

Aus US-A-4 875 190 ist eine zweidimensionale Speichereinheit bekannt, die in Matrixform angeordnete Speicherbausteine enthält. Jeder Speicherbaustein ist seinerseits ein in Matrixform organisierter zweidimensionaler Speicher mit wahlfreiem Zugriff. Alle Speicherbausteine sind gleich und werden mittels eines neun Bit breiten Adressbusses adressiert, wodurch gleichzeitig stets eine bestimmte, in allen Speicherbausteinen gleiche Matrixzelle auswählbar ist.

Der vorliegenden Erfindung liegt die Aufgabe zugrunde, eine Vorrichtung und ein Verfahren zum Speichern und Drehen von Bitmustern aufzuzeigen, bei der bei gleichbleibender Matrixgröße, die Anzahl der Verbindungsleitungen zwischen den Matrixzellen und der Matrixperipherie verringert wird.

Diese Aufgabe wird erfindungsgemäß durch die in den Patentansprüchen 1 und 4 angegebenen Merkmale gelöst. Ausführungen und Weiterbildungen der Erfindung sind in Unteransprüchen angegeben.

Durch das Zusammenfassen von mehreren Speicherzellen in einer Matrixzelle mit nur einem Ausgang und einer internen Datenselektion, wird der globale Verdrahtungsaufwand drastisch reduziert. Es können dadurch bei gegebenen technischen Möglichkeiten größere Speichermatrizen realisiert werden.

Welche Information in welcher Matrixzelle gespeichert wird kann im Hinblick auf schnelle Auslesbarkeit optimiert werden. Ist wie in Unteransprüchen angegeben zeilen- und spaltenweise Auslesbarkeit gewünscht, werden nur Pixel, deren Information nicht gleichzeitig ausgelesen werden muß, in den Speichertellen einer Matrixzelle zusammengefaßt. Durch das Klappen der originalen quadratischen Matrix über mindestens eine ihrer Diagonalen, werden solche Pixel gefunden. Die nach dem Klappen deckungsgleich übereinanderliegenden Pixel können in einer Matrixzelle zusammengefaßt werden. Bei entsprechend häufig geklappter originaler Matrix werden so Pixel einer Matrixposition für mehrere Drehrichtungen in den Speicherzellen einer Matrixzelle zusammengefaßt. Die Auswahl, welche Speicherzelle mit dem Datenausgang der Matrixzelle zur verbinden ist, wird durch das in der Matrixzelle vorgesehene interne Auswahlelement vorgenommen. Die Anzahl der dazu notwendigen Steuerleitungen ist gegenüber der Anzahl der eingesparten Verbindungsleitungen zwischen Matrixzellen und Matrixperipherie gering.

Ein Beispiel der Erfindung wird im folgenden anhand der Zeichnung näher erläutert. Dabei zeigen

Figur 1    eine Speichermatrix gemäß dem Stand der Technik,

Figur 2    eine schematische Darstellung einer Speichermatrix mit einer ersten Diagonale,

Figur 3    eine bereits einmal geklappte Speichermatrix mit einer weiteren Diagonale,

Figur 4    eine bereits zweimal geklappte Speichermatrix mit einer weiteren Diagonale,

Figur 5    eine einmal geklappte Speichermatrix mit Leitungsverbindungen von den Matrixzellen zu den peripheren Auswahlelementen,

Figur 6          eine zweimal geklappte Matrix mit Verbindungsleitungen von den Matrixzellen zu der Matrixperipherie,

Figur 7          eine zweimal geklappte Matrix mit Steuerleitungen zu den Auswahlelementen der Matrixzellen,

Figur 8          ein Schaltungsbeispiel einer Matrixzelle mit zwei Speicherzellen,

Figur 9          ein Schaltungsbeispiel einer Matrixzelle mit vier Speicherzellen,

Figur 10        eine Auslesesteuereinrichtung für eine Speichermatrix gemäß den Figuren 6 und 7,

Figur 11        eine Darstellung der Einzeloperationen beim Auslesen der Speichermatrix für verschiedene Drehrichtungen und

Figur 12        eine schematische Darstellung der Bildgenerierung eines Druckers.

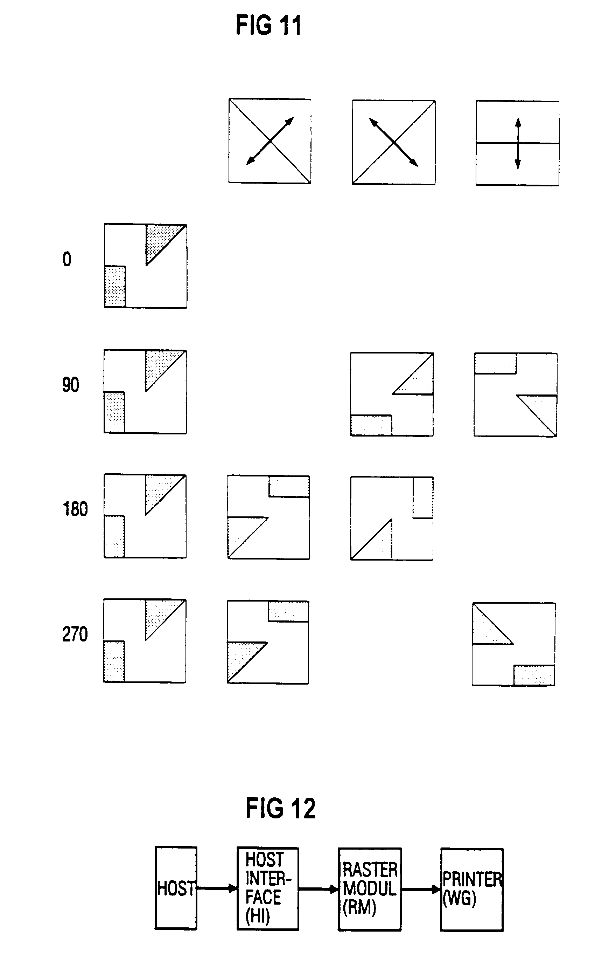

Figur 12 zeigt schematisch den Aufbau der Bildgenerierung eines Druckers. Von einem Computer HOST wird eine Bildinformation in codierter Form an eine Kanalschnittstelle HI (Host Interface) übergeben. Auf einem nachgeschalteten Raster Modul RM wird die codierte Bildinformation in ein Bitmuster umgesetzt. Dieses Rastermodul RM enthält unter anderem eine nachfolgend beschriebene Speichermatrix zum Speichern und Drehen von Bitmustern. Das im Raster Modul RM generierte Bitmuster wird an eine Wiedergabeeinheit WG, beispielsweise einen Drucker (PRINTER), ausgegeben.

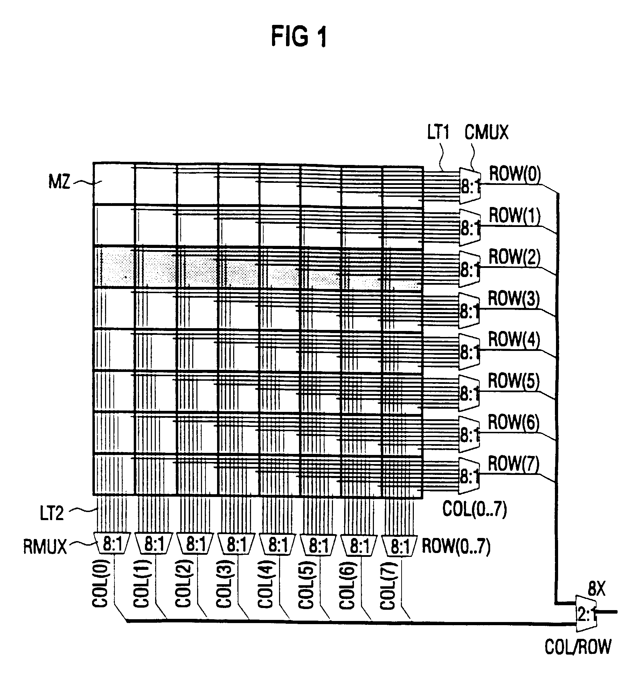

Figur 1 zeigt eine originale quadratische Matrix mit n=8 Spalten COL und n=8 Zeilen ROW. Jeder Spalte ist ein Zeilenmultiplexer RMUX zugeordnet. Jeder Zeilenmultiplexer RMUX ist über zweite Leitungen LT2 mit Datenausgängen von Matrixzellen MZ verbunden. Mittels des 8:1 Zeilenmultiplexers RMUX kann somit jeweils ein Datenausgang einer Matrixzelle MZ mit dem Ausgang des Zeilenmultiplexers RMUX verbunden werden. Damit kann mit Hilfe der Zeilenmultiplexer RMUX eine der Zeilen ROW(0..7) der Speichermatrix ausgelesen werden.

In der Matrixperipherie sind auch acht Spaltenmultiplexer CMUX angeordnet. Ein Eingang eines Spaltenmultiplexers CMUX ist jeweils mit einer Matrixzelle MZ einer Zeile ROW der Speichermatrix über eine erste Leitung LT1 verbunden. Dadurch kann der Ausgang des Spaltenmultiplexers CMUX mit einer der Matrixzellen MZ der jeweiligen Zeile ROW verbunden werden. Mit Hilfe der Spaltenmultiplexer CMUX ist somit eine Spalte COL(0..7) der Speichermatrix auslesbar. Bei dieser Speichermatrix gemäß dem Stand der Technik sind somit doppelt so viele Leitungen LT1, LT2 zwischen den Matrixzellen MZ und den Zeilen- bzw. Spaltenmultiplexern RMUX,CMUX erforderlich, wie Matrixzellen MZ vorhanden sind.

Bei einer solchen originalen quadratischen Matrix wird ein Drehen des in der Speichermatrix abgelegte Bitmusters in bekannter Weise vorgenommen. Beispielsweise wird anstelle einer Zeile ROW(0..7) eine Spalte COL(0..7) selektiert und anschließend die Bitreihenfolge im gelesenen Datenwort vertauscht.

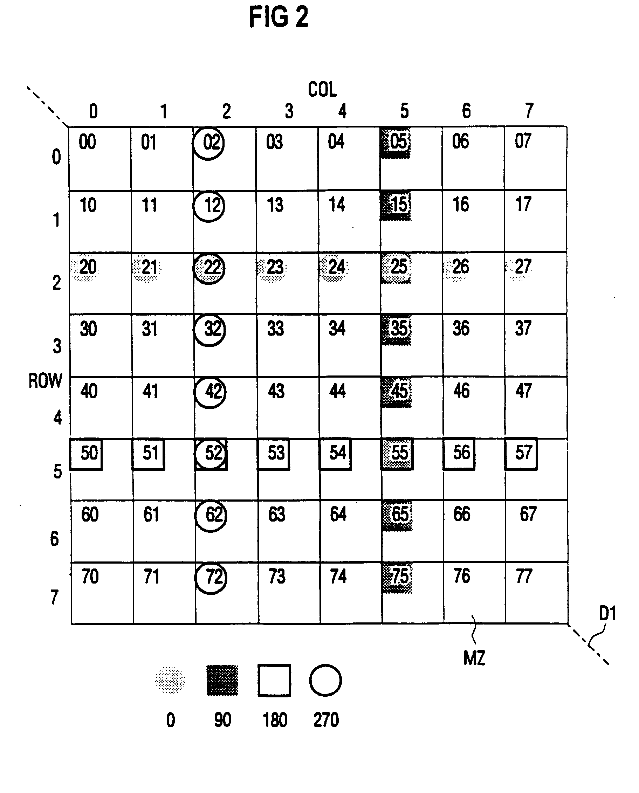

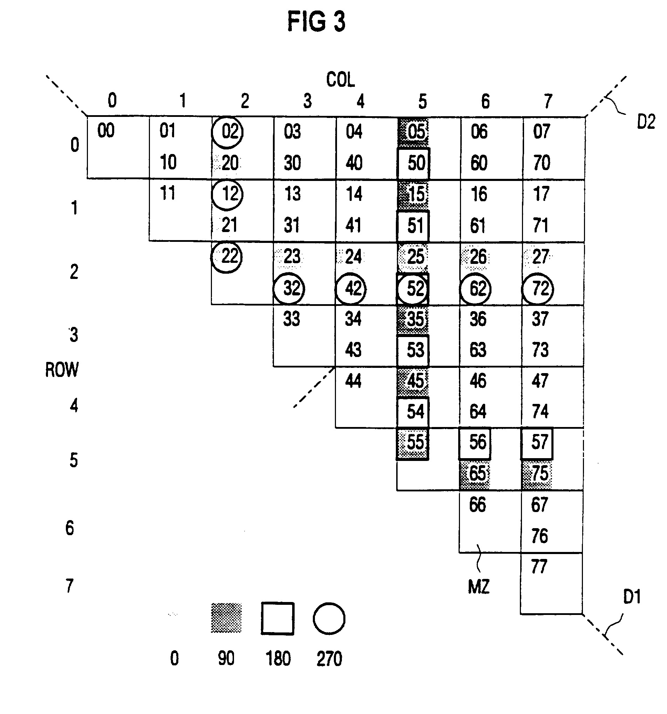

Gemäß der vorliegenden Erfindung kann nun die originale Matrix über ihre Diagonalen geklappt werden. Eine originale Matrix ist in Figur 2 dargestellt. In jeder Matrixzelle MZ ist ein Zellindize eingetragen. Die Matrixzelle MZ der Spalte Null COL(0) und der Zeile Null ROW (0) ist mit dem Indize 00 bezeichnet. Die anderen Matrixzellen MZ sind entsprechend bezeichnet. Die Matrixzellen MZ der Zeile zwei ROW(2) sind jeweils durch einen schraffierten Kreis markiert. Diese Markierung entspricht einer um 0° gedrehten Lage der Zeile 2 ROW(2). Die Matrixzellen MZ, in denen diese Zeile ROW(2) nach einer Drehung um jeweils weitere 90° liegt, sind in folgender Weise markiert: Ein schraffiertes Rechteck entspricht einer Drehung um 90°, ein quadratisches Kästchen entspricht einer Drehung um 180°, ein Kreis entspricht einer Drehung um 270°. Diagonal über die Speichermatrix verläuft von der Matrixzelle MZ mit dem Indize 00 zur Matrixzelle MZ mit dem Indize 77 eine erste Diagonale D1. Über diese erste Diagonale D1 wird die originale Matrix geklappt. Das Ergebnis dieses Klappvorganges ist in Figur 3 dargestellt.

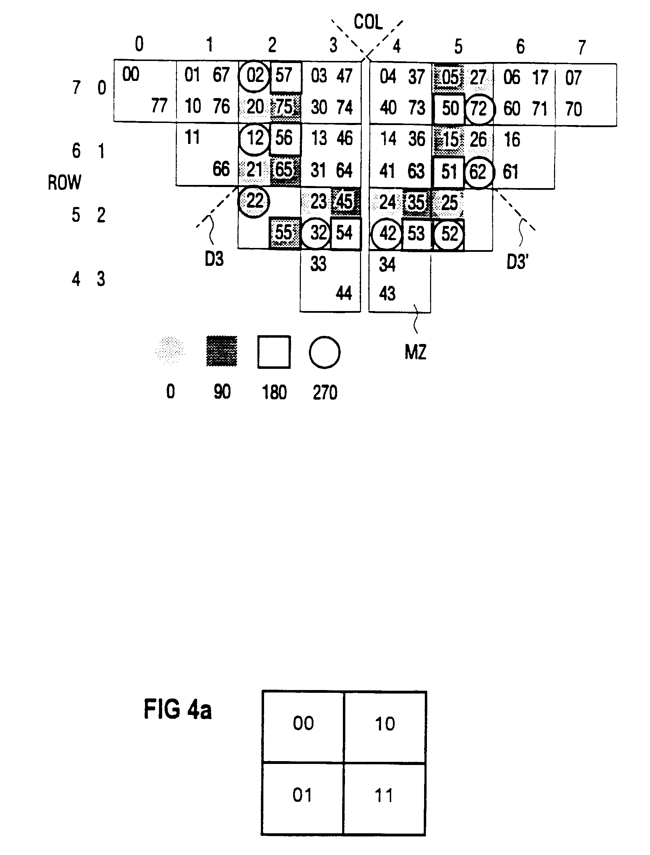

In den Matrixzellen MZ der Speichermatrix gemäß Figur 3 sind die Zellindizes der originalen Matrix eingetragen. Die Markierungen der Zeile 2 ROW(2) gemäß Figur 2 einschließlich ihrer Drehpositionen wurden beibehalten. Die Matrixzellen MZ entlang der Diagonale D1 sind unverändert. In den übrigen Matrixzellen MZ sind jedoch jeweils zwei Zellindizes eingetragen. Man erkennt anhand der Markierungen der verschiedenen Drehrichtungen der Zeile 2 ROW (2), daß sich die Zellindizes einer Spalte COL oder einer Zeile ROW jeweils in unterschiedlichen Matrixzellen MZ befinden. Jede Spalte COL oder Zeile ROW ist somit parallel auslesbar. Die Speichermatrix kann nun entlang einer zweiten Diagonale D2, die von der Matrixzelle MZ mit den Zellindizes 34, 43 zur Matrixzelle MZ mit den Zellindizes 07, 70 verläuft, ein zweites Mal geklappt werden. Das Ergebnis dieses Klappvorganges ist in Figur 4 dargestellt.

Man erkennt, daß in die Randzellen, die entlang der beiden Diagonalen D1, D2 angeordnet sind, jeweils zwei Zellindizes eingetragen sind. Die übrigen Matrixzellen MZ enthalten jeweils vier Zellindizes. Die Markierungen der verschiedenen Drehrichtungen der Zeile 2 ROW(2) gemäß Figur 2, wurden beibehalten. Auch hier ist gewährleistet, daß die Zellindizes einer Zeile ROW oder Spalte COL sich in verschiedenen Matrixzellen MZ befinden. Spalten COL oder Zeilen ROW können somit parallel ausgelesen werden. Die Matrix gemäß Figur 4 kann bei entsprechender Größe entlang einer dritten Diagonale D3, D3' weiter geklappt werden. Die dritte Diagonale D3 verläuft von der Matrixzelle MZ mit den Indizes 12,21,56,65 zur Matrixzelle MZ mit den Zellindizes 03,30,47,74 und die Diagonale D3' verläuft von der Matrixzelle MZ mit den Zellindizes 04,40,37,73 zur Matrixzelle MZ mit den Zellindizes 15,51,26,62.

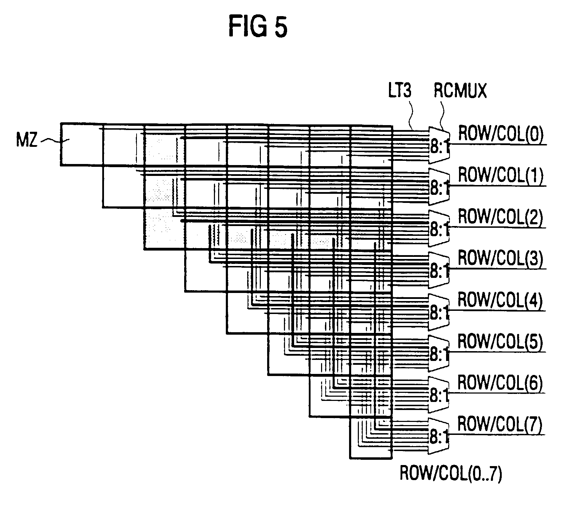

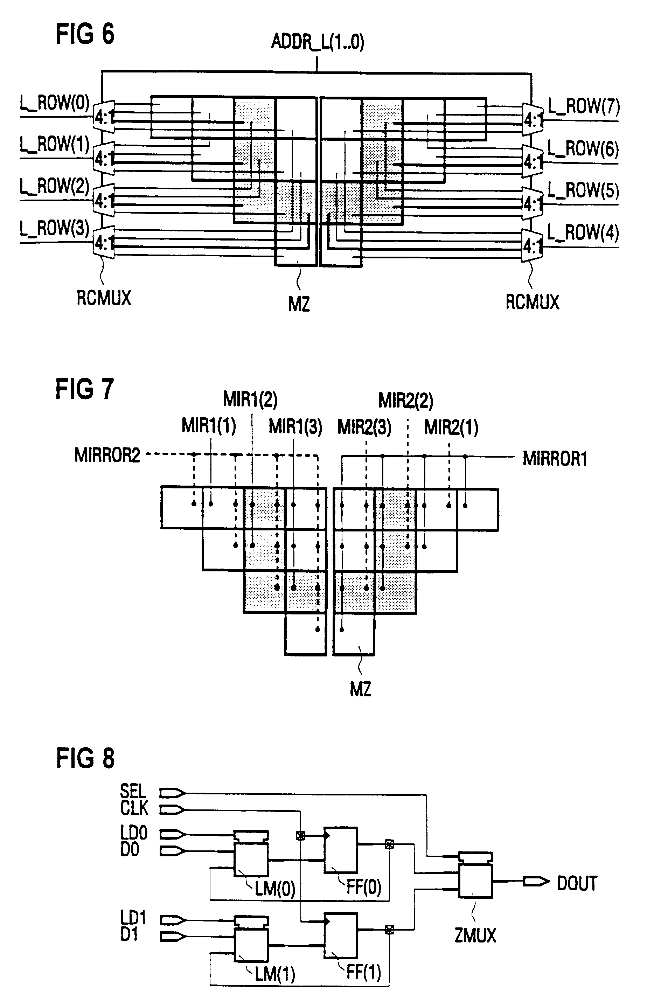

Die Beschaltung der geklappten Speichermatrizen gemäß den Figuren 3 und 4 zur Verbindung der Datenausgänge DOUT von Matrixzellen MZ mit der Wiedergabeeinrichtung WG, ist in den Figuren 5 und 6 dargestellt. Die Zellindizes der Spalte 2 COL(2) und der Zeile 2 ROW(2) der originalen Matrix befinden sich jeweils gemeinsam in einer Matrixzelle MZ. Die entsprechenden Matrixzellen MZ sind in den Figuren 5 und 6 schraffiert dargestellt.

Bei der Ausführungsform gemäß Figur 5 sind die Matrixzellen MZ über dritte Leitungen LT3 mit Spalten/Zeilenmultiplexern RCMUX verbunden. Durch das einmalige Klappen der Speichermatrix wird die Anzahl der peripheren Multiplexer RCMUX auf acht Stück halbiert, weil von außerhalb der Speichermatrix nicht mehr zwischen Spalten COL und Zeilen ROW unterschieden werden muß. Diese Unterscheidung erfolgt in den Matrixzellen MZ, wie unten näher erläutert wird.

Bei der zweimal geklappten Matrix gemäß Figur 6 werden ebenfalls acht Spalten/Zeilenmultiplexer RCMUX benötigt. Diese Spalten/Zeilenmultiplexer RCMUX weisen jedoch nur die Hälfte der Eingänge der Spalten/Zeilenmultiplexer RCMUX bei der einmal geklappten Matrix gemäß Figur 5 auf. Durch den zweiten Klappvorgang wird die Anzahl der Matrixzellen MZ der Speichermatrix so verringert, daß von außen nur mehr zwischen vier Zeilen ROW bzw. Spalten COL unterschieden werden muß. In einer Matrixzelle MZ stehen die Zellindizes von bis zu vier Matrixzellen MZ der originalen Matrix zur Verfügung. So stehen beispielsweise die Zellindizes der Zeile 2 ROW(2) für alle Drehrichtungen dieser Zeile ROW(2) in den schraffiert dargestellten Matrixzellen MZ (Figur 4).

Der Aufbau einer Matrixzelle MZ mit zwei Speicherzellen SZ (zwei Indizes) ist in Figur 8 dargestellt. Eine Speicherzelle SZ besteht aus einem Flip-Flop FF(0..1) und einem Lademultiplexer LM(0..1). Den Flip-Flops FF(0..1) wird ein Takt CLK zugeführt. Der Ausgang jedes Flip-Flops FF(0..1) ist zu einem Eingang des Lademultiplexers LM(0..1) zurückgeführt. Der andere Eingang des Lademultiplexers LM(0..1) ist über eine Datenleitung D(0..1) mit der Peripherie verbunden. Der Lademultiplexer LM(0..1) wird mittels einer Ladeleitung LD(0..1) zwischen einer Ladefunktion und einer Haltefunktion von außen umgeschaltet. Sollen also Pixel in eine Speicherzelle SZ geschrieben werden, dann ist an der Ladeleitung LD(0..1) eine entsprechende Information anzulegen, wodurch die an der Datenleitung D(0..1) anliegende Bildinformation in die Speicherzelle SZ geschrieben wird. Die Ladeleitungen LD(0..1) sind dazu mit einer nicht dargestellten Ladesteuerung gekoppelt. Die Ausgänge der Flip-Flops FF(0..1) sind jeweils mit einem Eingang eines als internes Auswahlelement dienenden Zellenmultiplexers ZMUX verbunden. Mit Hilfe dieses Zellenmultiplexers ZMUX wird einer der Ausgänge der Flip-Flops FF(0..1) zum Datenausgang DOUT der Matrixzelle MZ durchgeschaltet. Die Auswahl erfolgt mit Hilfe einer Auswahlleitung SEL.

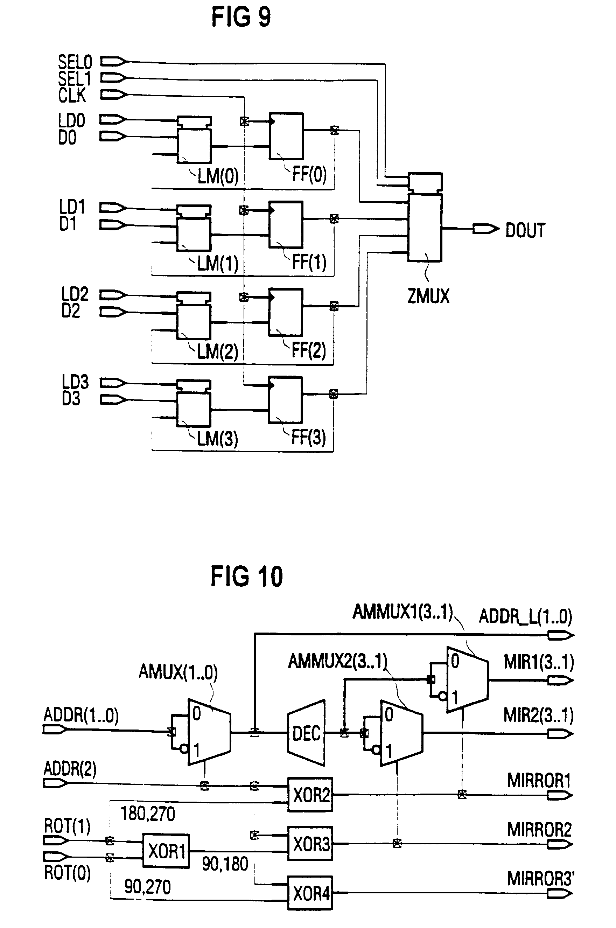

Eine Matrixzelle MZ, die vier Speicherzellen SZ enthält, ist wie in Figur 9 dargestellt aufgebaut. Der Aufbau der einzelnen Speicherzellen SZ dieser Matrixzelle MZ entspricht dem oben gemäß Figur 8 beschriebenen. Lediglich der Zellenmultiplexer ZMUX weist entsprechend der Anzahl der Speicherzellen SZ vier Eingänge auf, die wahlweise mit dem Datenausgang DOUT verbindbar sind. Zur Auswahl einer Speicherzelle SZ werden zwei Auswahlleitungen SEL (1..0) benötigt. Diese Auswahlleitungen SEL(1..0) sind mit einer Auslesesteuereinrichtung gemäß Figur 10 gekoppelt.

Figur 10 zeigt eine Auslesesteuereinrichtung zum Auslesen einer zweimal geklappten Matrix gemäß den Figuren 4, 6 und 7. Der Auslesesteuereinrichtung wird eine binär codierte Adresse ADDR(2..0) zugeführt, die eine auszulesende logische Zeile ROW angibt. Die beiden niederwertigen Adressenbits ADDR(1..0) werden einem negierenden und einem nicht negierenden Eingang eines Adreßmultiplexers AMUX zugeführt. Welcher der Eingänge zum Ausgang des Adreßmultiplexers durchgeschaltet wird, wird durch das höchstwertige Adreßbit ADDR(2) bestimmt. Der Ausgang des Adreßmulitplexers AMUX ist mit den Steuerleitungen ADDR_L(1..0) der Reihen/Spaltenmultiplexer RCMUX und mit dem Eingang eines Decoders DEC verbunden. Abhängig von der Adresse ADDR(2..0) wird damit eine logische Zeile L_ROW(0..7) der Speichermatrix ausgewählt.

Am Ausgang des Decoders DEC sind die Eingänge zweier weiterer Adreßmultiplexer AMMUX1, AMMUX2 gekoppelt. Das niederwertigste Bild des Decoders DEC wird nicht verwendet. Jeder dieser weiteren Adreßmultiplexer AMMUX weist einen nicht invertierenden und einen invertierenden Eingang auf, die wahlweise zum Ausgang durchschaltbar sind. Der Ausgang des einen Adreßmultiplexers AMMUX1 ist mit einem ersten Steuerleitungsbündel MIR1(3..1) gekoppelt. Der Ausgang des zweiten Adreßmultiplexers AMMUX2 ist mit einem zweiten Steuerleitungsbündel MIR2 (3..1) gekoppelt. Die beiden Adreßmulitplexer AMMUX1, AMMUX2 werden abhängig vom höchstwertigen Adreßbit ADDR(2) und von einer an Drehungsleitungen ROT(1..0) anliegenden Drehungsinformation geschaltet. Das höchstwertige Adreßbit ADDR(2) und die Drehungsinformation werden durch vier EXKLUSIV-ODER-Gatter XOR1, XOR2, XOR3, XOR4 miteinander verknüpft. Die Drehungsleitungen ROT(1..0) sind an die beiden Eingänge des ersten EXKLUSIV-ODER-Gatters XOR1 und an je einen Eingang des zweiten EXKLUSIV-ODER-Gatters XOR2 und des vierten EXKLUSIV-ODER-Gatters XOR4 gekoppelt. Der Ausgang des ersten EXKLUSIV-ODER-Gatters XOR1 ist mit einem Eingang des dritten EXKLUSIV-ODER-Gatters XOR3 gekoppelt. Das höchstwertige Adreßbit ADDR(2) ist an je einen Eingang des zweiten, dritten und vierten EXKLUSIV-ODER-Gatters XOR2, XOR3, XOR4 gekoppelt. Der Ausgang des zweiten EXKLUSIV-ODER-Gatters XOR2 schaltet den Adreßmultiplexer AMMUX1 um und ist mit der Leitung MIRROR1 gekoppelt. Der Ausgang des dritten EXKLUSIV-ODER-Gatters XOR3 schaltet den Adreßmultiplexer AMMUX2 um und ist der Leitung MIRROR2 gekoppelt. Der Ausgang des vierten EXKLUSIV-ODER-Gatters XOR4 ist mit der Leitung MIRROR3' gekoppelt.

Wie Figur 7 zeigt, sind die Steuerleitungen MIR1, MIR2, MIRROR1, MIRROR2 mit den Auswahlleitungen SEL(1..0) der Zellenmultiplexer ZMUX gekoppelt. Die Speichermatrix ist in zwei symmetrisch aufgebaute Teile gegliedert. Die linke Hälfte bilden dabei die Spalten COL(0...3), und die rechte Hälfte bilden die Spalten COL(4..7). Jede der Matrixzellen MZ der linken Hälfte der Speichermatrix ist mit der vierten Steuerleitung MIRROR2 gekoppelt. Die vierte Steuerleitung MIRROR2 ist dazu in den Randzellen (zwei Speicherzellen) mit der Auswahlleitung SEL und in den Kernzellen (vier Speicherzellen) mit der Auswahlleitung SEL1 des Zellenmultiplexers ZMUX verbunden. Die Auswahlleitungen SEL0 der Kernzellen der linken Hälfte der Speichermatrix sind spaltenweise jeweils mit einer der ersten Steuerleitungen MIR1(3..1) verbunden.

Die Auswahlleitungen SEL der Randzellen und die Auswahlleitungen SEL0 der Kernzellen der rechten Hälfte der Speichermatrix, sind mit der dritten Steuerleitung MIRROR1 verbunden. Die Auswahlleitungen SEL1 der Kernzellen der rechten Hälfte der Speichermatrix sind spaltenweise jeweils mit einer der zweiten Steuerleitungen MIR2(3..1) verbunden.

Die fünfte Steuerleitung MIRROR3' steuert eine nicht dargestellte, in Zeilenbreite aufgebaute Multiplexeranordnung. An die Eingänge der 2:1 Multiplexeranordnung sind die Ausgänge der Reihen/Spaltenmultiplexer RCMUX so angeschlossen, daß die ersten Eingänge der Multiplexeranordnung mit der logischen Zeile L_ROW(0..7) in aufsteigender Reihenfolge gekoppelt sind und an den zweiten Eingängen der Multiplexeranordnung die logische Zeile L_ROW (7..0) in umgekehrter Reihenfolge gekoppelt sind. Durch Signalumkehr an der fünften Steuerleitung MIRROR3' kann somit die Bitfolge einer ausgelesenen logischen Zeile L_ROW(0..7) bzw. L_ROW(7..0) umgekehrt werden.

Figur 11 zeigt eine schematische Darstellung der Drehung eines Bitmusters. In vertikaler Richtung übereinander sind vier unterschiedliche Drehpositionen, nämlich eine Drehung um 0°, eine Drehung um 90°, eine Drehung um 180° und eine Drehung um 270° dargestellt. In horizontaler Richtung sind die dazugehörigen Operationen dargestellt, die ausgehend von einer Drehung um 0° erforderlich sind, um zur gewünschten Drehposition zu gelangen. Für eine Drehung um 0° sind demnach keinerlei Operationen erforderlich. Für eine Drehung um 90° ist eine Spiegelung an der zweiten Diagonale D2 (MIRROR2)und anschließendes Spiegeln der Zeilenhalbierenden (verläuft zwischen row3 und row4) der Speichermatrix (MIRROR3') erforderlich. Bei einer Drehung um 180° sind eine Spiegelung an der ersten und an der zweiten Diagonale (MIRROR1, MIRROR2) erforderlich. Für eine Drehung um 270° ist eine Spiegelung an der ersten Diagonale D1 (MIRROR1) mit anschließendem Spiegeln der Zeilen an der Zeilenhalbierenden der Speichermatrix (MIRROR3') erforderlich. Die Spiegelung an der Zeilenhalbierenden (MIRROR3') entspricht einer Spiegelung an der Spaltenhalbierenden in der originalen Matrix, weil dieser Spiegelung eine Spiegelung an der ersten oder an der zweiten Diagonale D1, D2 vorausgeht.

Die jeweiligen Operationen können mit Hilfe der erfindungsgemäßen Speichermatrix und deren Auslesesteuereinrichtung durchgeführt werden. Dieser Auslesevorgang wird im folgenden anhand der Figuren 4, 4a, 6, 7 und 10 erläutert. Die Adresse ADDR(2..0) für die ausgewählte Zeile 2 ROW(2) ist 010. Es erfolgt eine Drehung um 180°. An der Drehungsleitung ROT(1) liegt eine logische 1, und an der Drehungsleitung ROT(0) liegt eine logische Null vor. Am Ausgang des ersten EXKLUSIV-ODER-Gatters XOR1 liegt entsprechend eine logische 1 vor. An der dritten Steuerleitung MIRROR1 liegt folglich eine logische 1, an der vierten Steuerleitung MIRROR2 eine logische 1 und an der fünften Steuerleitung MIRROR3' eine logische 0 vor. Der Adreßmultiplexer AMUX gibt die beiden niederwertigen Adreßbit ADDR(1..0) unverändert zur Steuerleitung ADDR_L(1..0) aus. Die in den Figuren 4, 6 und 7 schraffierten Matrixzellen MZ werden dadurch ausgewählt. Der Decoder DEC arbeitet nach folgender Wahrheitstabelle:

| ADDR(1) | ADDR(0) | MSB | | | LSB |
|---------|---------|-----|---|---|-----|
| 0 | 0 | 0 | 0 | 0 | 1 |
| 0 | 1 | 0 | 0 | 1 | 0 |
| 1 | 0 | 0 | 1 | 0 | 0 |
| 1 | 1 | 1 | 0 | 0 | 0 |

Das niederwertigste Bit LSB dieser Wahrheitstabelle wird nicht benötigt. Die anderen drei Bits werden von den Adreßmultiplexern AMMUX1, AMMUX2 negiert. Entsprechend gilt für die logischen Zustände, die an den ersten und zweiten Steuerleitungen vorliegen, folgende Zuordnung:

| MIR1(3) | 1 | MIR2(3) | 1 |
|---------|---|---------|---|
| MIR1(2) | 0 | MIR2(2) | 0 |

(fortgesetzt)

| MIR1(1) | 1 | MIR2(1) | 1 |
|---------|---|---------|---|

Die einzelnen Speicherzellen SZ der Kernzellen gemäß Figur 4 seien zum leichteren Verständnis gemäß der Darstellung in Figur 4a angeordnet. Das höherwertige Bit gibt den an der zweiten Auswahlleitung SEL(1) vorliegenden logischen Zustand an und das niederwertige Bit gibt den logischen Zustand an der ersten Auswahlleitung SEL(0) an. Gemäß den oben beschriebenen Verbindungen zwischen den Auswahlleitungen SEL(1..0) und den Steuerleitungen MIR1(3..1), MIRROR2 in der linken Hälfte der Speichermatrix liegt in der Matrixzelle MZ der Spalte 2 COL(2) und der Zeile 7 bzw. 0 ROW(7 0) folgendes Steuersignal vor:

SEL0 = 0 = MIR1(2) und SEL1 = 1 = MIRROR2.

Es wird demzufolge die Speicherzelle SZ mit dem Indize 57 ausgewählt. Entsprechendes gilt für die übrigen Zellen der linken Hälfte der Speichermatrix.

In der rechten Hälfte der Speichermatrix sind die oben beschriebenen Verbindungen zwischen den Steuerleitungen MIRROR1, MIR2(3..1) und den Auswahlleitungen SEL(0), SEL(1) realisiert. Entsprechend liegt beispielsweise in der Matrixzelle der Spalte 5 COL(5) und der Zeile 6 bzw. 1 ROW(6 1) folgendes Steuersignal vor:

SEL0 = 1 = MIRROR1 und SEL1 = 0 = MIR2(2)

Es wird demzufolge die Speicherzelle SZ mit dem Indize 51 ausgewählt. Entsprechendes gilt für die übrigen Zellen der rechten Hälfte der Speichermatrix.

Damit steht am Ausgang der Reihen/Spaltenmultiplexer RCMUX der um 180° gedrehte Inhalt der Zeile 5 ROW (5) parallel zur Verfügung. Nacheinander werden auf diese Weise alle Zeilen 0 bzw. 7 ROW(0..7) um 180° gedreht ausgelesen.

Bei einer Drehung um 90 oder 270° müssen entsprechend andere logische Zustände an den Drehungsleitungen ROT(1..0) gemäß nachfolgender Tabelle eingestellt werden:

| Drehung | ROT(1) | ROT(0) |
|---------|--------|--------|
| 0°      | 0      | 0      |
| 90°     | 0      | 1      |
| 180°    | 1      | 0      |
| 270°    | 1      | 1      |

Mittels der Auslesesteuereinrichtung werden diese logischen Zustände der Drehungsleitungen ROT(1..0) so umgesetzt, daß im Falle einer Drehung um 90° eine Spiegelung an der zweiten Diagonale D2 und im Falle einer Drehung um 270° eine Spiegelung an der ersten Diagonale D1 durchgeführt wird. In beiden Fällen wird durch die Multiplexeranordnung, an der mittels der fünften Steuerleitung MIRROR3' eine logische Eins anliegt, ein Vertauschen der Reihenfolge der ausgelesenen Bitinformation durchgeführt.

Speichermatrizen unterschiedlicher Größen können auf diese Weise unter Einsparung einer großen Anzahl von Leitungen aufgebaut werden. Nachstehende Tabelle gibt, abhängig von der Matrixgröße und der Anzahl der Klappvorgänge der Matrix, das Einsparungspotential an Leitungen an.

| Matrixgröße | n | 8 | 16 | 32 | 64 |
|-------------|---|---|----|----|----|
| Speicherzellen (SZ) | $n^2$ | 64 | 256 | 1024 | 4096 |
| Ausgangsleitungen (LT) | $2*n^2$ | 128 | 512 | 2048 | 8192 |
| Matrixzellen (MZ) 1) | $(n^2/2)+(n/2)$ | 36 | 136 | 528 | 2080 |
| Ausgangsleitungen(LT)1) | $n^2$ | 64 | 256 | 1024 | 4096 |
| Steuerleitungen(MIR)1) | n | 8 | 16 | 32 | 64 |
| Matrixzellen (MZ) 2) | $(n^2/4)+(n/2)$ | 20 | 72 | 272 | 1056 |
| Ausgangsleitungen(LT)2) | $n^2/2$ | 32 | 128 | 512 | 2048 |
| Steuerleitungen(MIR)2) | n+1 | 9 | 17 | 33 | 65 |

1) Matrix einmal geklappt
2) Matrix zweimal geklappt

(fortgesetzt)

| Ausgangsleitungen(LT)x) | n^2/2^x | | | | |
|---|---|---|---|---|---|
| Matrixzellen x) | (n^2/2^x)+(n/2) | | | | |
| Eingesparte Leitungen1) | (LT)-(LT)1)-(MIR)1) | 56 | 240 | 992 | 4032 |
| Eingesparte Leitungen2) | (LT)-(LT)2)-(MIR)2) | 87 | 367 | 1503 | 6079 |

1) Matrix einmal geklappt
2) Matrix zweimal geklappt
x) Matrix x-mal geklappt

So werden beispielsweise bei einer originalen Matrix mit der Größe n=8, die zweimal geklappt wurde 87 Ausgangsleitungen unter Berücksichtigung der zusätzlich erforderlichen Steuerleitungen MIR eingespart.

**Patentansprüche**

1. Verfahren zum Speichern und Drehen von Bitmustern in einem Raster-Modul (RM), das eine eine Mehrzahl von Matrixzellen (MZ) enthaltende, über periphere Auswahlelemente (RCMUX) mit einer Wiedergabeeinrichtung (WG) koppelbare Speichermatrix aufweist, mit folgenden Verfahrensschritten:

   - Abspeichern eines in Form von Pixeln einer originalen Matrix vorliegenden Bitmusters derart, daß in jeder Matrixzelle (MZ) der Speichermatrix wenigstens ein Pixel der originalen Matrix abgespeichert wird, und
   - Auslesen des Bitmusters aus der Speichermatrix, wobei abhängig von einer Drehinformation bestimmte Matrixzellen (MZ) ausgewählt werden,

   dadurch gekennzeichnet daß abhängig von der Drehinformation innerhalb der ausgewählten Matrixzellen (MZ) je ein Pixel mittels eines internen Auswahlelementes (ZMUX) ausgewählt und zur Wiedergabeeinrichtung (WG) ausgelesen wird.

2. Verfahren zum Speichern und Drehen von Bitmustern nach Anspruch 1, bei dem die Pixel der originalen Matrix derart in den Matrixzellen (MZ) der Speichermatrix abgespeichert werden, daß jede Matrixzelle (MZ) die Pixel enthält, die nach Klappen der originalen Matrix über mindestens eine ihrer Diagonalen (D) zueinander deckungsgleich sind.

3. Verfahren zum Speichern und Drehen von Bitmustern nach einem der Ansprüche 1 oder 2 mit einem einem elektrografischen Drucker zugeordneten Raster-Modul (RM), in dessen Speichermatrix das Bitmuster zeilen- oder spaltenweise abgespeichert wird und zeilen- oder spaltenweise ausgelesen wird.

4. Raster-Modul (RM) zum Speichern und Drehen von Bitmustern, das enthält:

   - eine eine Mehrzahl von Matrixzellen (MZ) enthaltende, über periphere Auswahlelemente (RCMUX) mit einer Wiedergabeeinrichtung (WG) koppelbare Speichermatrix,
   - wenigstens eine Speicherzelle (SZ) pro Matrixzelle (MZ) zum abspeichern eines in Form von Pixeln einer originalen Matrix vorliegenden Bitmusters derart, daß in jeder Matrixzelle (MZ) der Speichermatrix wenigstens ein Pixel der originalen Matrix speicherbar ist, und
   - interne Auswahlelemente (ZMUX) in den Matrixzellen (MZ) zum Auswählen bestimmter Speicherzellen (SZ) innerhalb der Matrixzellen (MZ) und zum Koppeln der Ausgänge dieser Speicherzellen (SZ) mit der Wiedergabeeinrichtung (WG),
   - gekennzeichnet durch eine Auslesesteuereinrichtung, die abhängig von einer Drehinformation des Bitmusters die Auswahlelemente (ZMUX, RCMUX) ansteuert.

5. Raster-Modul (RM) zum Speichern und Drehen von Bitmustern, nach Anspruch 4, bei der die Bitmuster Zeilen- oder Spaltenweise zur Wiedergabeeinrichtung (WG) auslesbar sind, mit

   - Matrixzellen (MZ), die

- jeweils einen Datenausgang (DOUT) aufweisen,
- jeweils Speicherzellen (SZ) zur Aufnahme der Pixel einer originalen quadratischen Matrix enthalten, die bei Klappen dieser originalen Matrix an mindestens einer ihrer Diagonalen (D) übereinanderliegen,
- jeweils ein internes Auswahlelement (ZMUX) zum Koppeln ihres Datenausgangs (DOUT) mit jeweils einer der in ihr enthaltenen Speicherzellen (SZ) enthalten, und

- peripheren Auswahlelementen (RCMUX) zur wahlweisen Koppelung der Datenausgänge (DOUT) von Matrixzellen (MZ) mit der Wiedergabeeinrichtung (WG).

6. Raster-Modul (RM) zum Speichern und Drehen von Bitmustern, nach einem der Ansprüche 4 oder 5, mit einer vor der Wiedergabeeinrichtung (WG) angeordneten Vertauschungseinrichtung, die wahlweise, abhängig von ihrer Ansteuerung durch die Auslesesteuereinrichtung die Reihenfolge der Pixel einer ausgelesenen Spalte (COL) oder Zeile (ROW) umkehrt.

7. Raster-Modul (RM) zum Speichern und Drehen von Bitmustern, nach einem der Ansprüche 4 bis 6, mit einer Speichermatrix zum Speichern einer x-mal an ihren Diagonalen (D) geklappten originalen Matrix mit n Spalten (COL) und n Zeilen (ROW), wobei die Speichermatrix $\frac{n^2}{2^x} + \frac{n}{2}$ Matrixzellen (MZ) aufweist.

8. Elektrografischer Drucker mit einem Raster-Modul (RM) zum Speichern und Drehen von Bitmustern nach einem der Ansprüche 4 bis 7.

## Claims

1. Method for storing and rotating bit patterns in a raster module (RM), which has a storage matrix that contains a plurality of matrix cells (MZ) and can be coupled to a reproduction device (WG) via peripheral selection elements (RCMUX), having the following method steps:

- storage of a bit pattern present in the form of pixels of an original matrix, in such a way that at least one pixel of the original matrix is stored in each matrix cell (MZ) of the storage matrix, and
- read-out of the bit pattern from the storage matrix, specific matrix cells (MZ) being selected as a function of a rotation information item,

characterized in that, as a function of the rotation information item, a respective pixel within the selected matrix cells (MZ) is selected by means of an internal selection element (ZMUX) and is read out to the reproduction device (WG).

2. Method for storing and rotating bit patterns according to Claim 1, in which the pixels of the original matrix are stored in the matrix cells (MZ) of the storage matrix in such a way that each matrix cell (MZ) contains the pixels which are congruent with respect to one another after the original matrix has been folded across at least one of its diagonals (D).

3. Method for storing and rotating bit patterns according to either of Claims 1 and 2, with a raster module (RM) which is assigned to an electrographic printer, the bit pattern being stored in a row-by-row or column-by-column manner in the storage matrix of the said raster module and being read out in a row-by-row or column-by-column manner from the said raster module.

4. Raster module (RM) for storing and rotating bit patterns, which contains:

- a storage matrix that contains a plurality of matrix cells (MZ) and can be coupled to a reproduction device (WG) via peripheral selection elements (RCMUX),
- at least one storage cell (SZ) per matrix cell (MZ) for storing a bit pattern present in the form of pixels of an original matrix, in such a way that at least one pixel of the original matrix can be stored in each matrix cell (MZ) of the storage matrix, and
- internal selection elements (ZMUX) in the matrix cells (MZ) for selecting specific storage cells (SZ) within the matrix cells (MZ) and for coupling the outputs of these storage cells (SZ) to the reproduction device (WG),
- characterized by a read-out control device, which drives the selection elements (ZMUX, RCMUX) as a function of a rotation information item of the bit pattern.

5. Raster module (RM) for storing and rotating bit patterns, according to Claim 4, in which the bit patterns can be read out in a row-by-row or column-by-column manner to the reproduction device (WG), having

- matrix cells (MZ) which

  - each have a data output (DOUT),
  - each contain storage cells (SZ) for accommodating the pixels of an original square matrix which lie above one another when this original matrix is folded at at least one of its diagonals (D),
  - each contain an internal selection element (ZMUX) for coupling its data output (DOUT) to in each case one of the storage cells (SZ) contained in it, and

- peripheral selection elements (RCMUX) for the optional coupling of the data outputs (DOUT) of matrix cells (MZ) to the reproduction device (WG).

6. Raster module (RM) for storing and rotating bit patterns, according to either of Claims 4 and 5, having an interchanging device that is arranged upstream of the reproduction device (WG) and optionally, as a function of its driving by the read-out control device, reverses the order of the pixels of a column (COL) or row (ROW) that is read out.

7. Raster module (RM) for storing and rotating bit patterns, according to one of Claims 4 to 6, having a storage matrix for storing an original matrix having n columns (COL) and n rows (ROW) which is folded x times at its diagonals (D), the storage matrix having $\frac{n^2}{2^x} + \frac{n}{2}$ matrix cells (MZ).

8. Electrographic printer having a raster module (RM) for storing and rotating bit patterns according to one of Claims 4 to 7.

## Revendications

1. Procédé pour mémoriser et faire tourner des configurations de bits dans un module de trame (RM) qui présente une matrice de mémoire contenant une pluralité de cellules de matrice (MZ) et qui peut être couplée à un dispositif de reproduction (WG) par l'intermédiaire d'éléments sélecteurs périphériques (RCMUX), et comportant les phases de procédé suivantes :

   - mémoriser une configuration de bits présente sous la forme de pixels d'une matrice initiale, de telle manière qu'au moins un pixel de la matrice initiale soit mémorisé dans chaque cellule de matrice (MZ) de la matrice de mémoire, et
   - lire la configuration de bits dans la matrice de mémoire, des cellules de matrice (MZ) déterminées étant sélectionnées en fonction d'une information de rotation, caractérisé en ce qu'en fonction de l'information de rotation, un pixel est sélectionné au moyen d'un élément de sélection interne (ZX) dans chacune des cellules de matrice (MZ) sélectionnées, et lu pour être transmis au dispositif de reproduction (WG).

2. Procédé pour mémoriser et faire tourner des configurations de bits selon la revendication 1, dans lequel les pixels de la matrice initiale sont mémorisés dans les cellules de matrice (MZ) de la matrice de mémoire de telle manière, que chaque cellule de matrice (MZ) contienne les pixels qui sont superposés entre eux après repliage de la matrice initiale autour d'au moins une de ses diagonales (D).

3. Procédé pour mémoriser et faire tourner des configurations de bits selon une des revendications 1 et 2, comprenant un module de trame (RM) correspondant à une imprimante électrographique, dans la matrice de mémoire duquel la configuration de bits est mémorisée par lignes ou par colonnes et lue par lignes ou par colonnes.

4. Module de trame (RM) pour mémoriser et faire tourner des configurations de bits, qui comprend :

   - une matrice de mémoire comprenant une pluralité de cellules de matrice (MZ) et qui peut être couplée à un dispositif de reproduction (WG) par l'intermédiaire d'éléments sélecteurs périphériques (RCMUX),
   - au moins une cellule de mémoire (SZ) par cellule de matrice (MZ) pour mémoriser une configuration de bits présente sous la forme de pixels d'une matrice initiale, de telle manière qu'au moins un pixel de la matrice initiale puisse être mémorisé dans chaque cellule de matrice (MZ) de la matrice de mémoire, et

    - des éléments sélecteurs internes (ZMUX) dans les cellules de matrice (MZ) pour sélectionner des lignes de mémoire (SZ) déterminées à l'intérieur des cellules de matrice (MZ) et pour coupler les sorties de ces cellules de mémoire (SZ) au dispositif de reproduction (WG),

caractérisé par un dispositif de commande de lecture qui commande les éléments sélecteurs (ZMUX) en fonction d'une information de rotation de la configuration de bits.

**5.** Module de trame (RM) pour mémoriser et faire tourner des configurations de bits selon la revendication 4, dans lequel les configurations de bits peuvent être lues par lignes ou par colonnes pour être transmises au dispositif de reproduction (WG), comprenant :

    - des cellules de matrice (MZ) qui

        - présentent chacune une sortie de données (DOUT)
        - contiennent chacune des cellules de mémoire (MZ) destinées à recevoir les pixels d'une matrice initiale carrée, qui sont superposés lorsque cette matrice initiale est repliée autour d'au moins une de ses diagonales (D),
        - contiennent chacune un élément sélecteur interne (ZMUX) destiné à coupler sa sortie de données (DOUT) à une, respective, des cellules de mémoire (SZ) qui y sont contenues, et

    - des éléments sélecteurs périphériques (RCMUX) destinés à coupler sélectivement les sorties de données (DOUT) de cellules de matrice (MZ) au dispositif de reproduction (WG).

**6.** Module de trame (RM) destiné à mémoriser et faire tourner des configurations de bits selon une des revendications 4 et 5, comprenant un dispositif de permutation disposé en amont du dispositif de reproduction (WG), qui inverse sélectivement, en fonction de sa commande par le dispositif de commande de lecture, l'ordre de succession des pixels d'une colonne (COL) ou d'une ligne (ROW) sélectionnée.

**7.** Module de trame (RM) pour mémoriser et faire tourner des configurations de bits selon une des revendications 4 à 6, comprenant une matrice de mémoire pour mémoriser une matrice initiale repliée X fois autour de ses diagonales (D), et comprenant $\underline{n}$ colonnes (COL) et $\underline{n}$ lignes (ROW), la matrice de mémoire présentant $\frac{n}{2^x} + \frac{n}{2}$ cellules de matrice (MZ).

**8.** Imprimante électrographique, comprenant un module de trame (RM) selon une des revendications 4 à 7 pour mémoriser et faire tourner des configurations de bits.

# FIG 1

# FIG 2

COL

|  | 0 | 1 | 2 | 3 | 4 | 5 | 6 | 7 |
|---|---|---|---|---|---|---|---|---|
| 0 | 00 | 01 | (02) | 03 | 04 | 05 | 06 | 07 |
| 1 | 10 | 11 | (12) | 13 | 14 | 15 | 16 | 17 |
| 2 | 20 | 21 | (22) | 23 | 24 | (25) | 26 | 27 |
| 3 | 30 | 31 | (32) | 33 | 34 | 35 | 36 | 37 |
| 4 | 40 | 41 | (42) | 43 | 44 | 45 | 46 | 47 |
| 5 | 50 | 51 | (52) | 53 | 54 | 55 | 56 | 57 |
| 6 | 60 | 61 | (62) | 63 | 64 | 65 | 66 | 67 |
| 7 | 70 | 71 | (72) | 73 | 74 | 75 | 76 | 77 |

ROW

D1

MZ

0    90    180    270

# FIG 3

COL

| 0 | 1 | 2 | 3 | 4 | 5 | 6 | 7 |

**7  0**

00    01 67 (02) 57   03 47    04 37 05 27   06 17   07
77   10 76 20 75   30 74    40 73 50 (72) 60 71   70

**6  1**

11   (12) 56   13 46    14 36 15 26   16
66   21 65   31 64    41 63 51 (62) 61

ROW

**5  2**

(22)    23 45   24 35 25
55 (32) 54   (42) 53 (52)

D3          33    34       D3'

**4  3**

44    43

MZ

| ▦ (0) | ◼ (90) | ☐ (180) | ◯ (270) |

0    90    180    270

**FIG 4a**

| 00 | 10 |
|----|----|
| 01 | 11 |

# FIG 5

## FIG 6

ADDR_L(1..0)

L_ROW(0) 4:1
L_ROW(1) 4:1
L_ROW(2) 4:1
L_ROW(3) 4:1

L_ROW(7) 4:1
L_ROW(6) 4:1
L_ROW(5) 4:1
L_ROW(4) 4:1

RCMUX

MZ

RCMUX

## FIG 7

MIR1(2)                    MIR2(2)

MIR1(1)        MIR1(3)    MIR2(3)        MIR2(1)

MIRROR2                                              MIRROR1

MZ

## FIG 8

SEL
CLK
LD0
D0

LM(0)      FF(0)

ZMUX

DOUT

LD1
D1

LM(1)      FF(1)

# FIG 9

# FIG 10

# FIG 11

# FIG 12